Europäisches Patentamt

European Patent Office

Office européen des brevets

(11) Publication number: **0 205 728 B1**

# EUROPEAN PATENT SPECIFICATION

(45) Date of publication of patent specification: **15.07.92**

(51) Int. Cl.⁵: **H01L 23/48**, H01L 23/50, H01L 23/66

(21) Application number: **86100573.4**

(22) Date of filing: **17.01.86**

(54) **Arrangement of input-output pins of an integrated circuit package.**

(30) Priority: **17.06.85 JP 129924/85**

(43) Date of publication of application:
**30.12.86 Bulletin 86/52**

(45) Publication of the grant of the patent:
**15.07.92 Bulletin 92/29**

(84) Designated Contracting States:
**DE FR GB**

(56) References cited:
**US-A- 4 340 902**

**MOTOROLA INTEGRATED LINEAR CIRCUITS, 1980, page 7.13, MC-3468, Motorola Inc., CH; "Magnetic memories to TTL systems"**

**THE TTL DATA BOOK FOR DESIGN ENGINEERS, 4th edition, 1980, pages 5-6 SN5400W, 5-49SN74186, Texas Instruments, DE; "Families of compatible TTL circuits"**

**PATENT ABSTRACTS OF JAPAN, vol. 9, no. 95 (E-310)[1818], 24th April 1985; & JP-A-59 222 949**

(73) Proprietor: **KABUSHIKI KAISHA TOSHIBA 72, Horikawa-cho Saiwai-ku Kawasaki-shi Kanagawa-ken 210(JP)**

(72) Inventor: **Nakanishi, Koji 1-2 Ooki-Coopo 1-13-4, Furuichiba Saiwai-ku Kawasaki-shi Kanagawa-ken(JP)**

(74) Representative: **Lehn, Werner, Dipl.-Ing. et al Hoffmann, Eitle & Partner Patentanwälte Arabellastrasse 4 W-8000 München 81(DE)**

## Description

The present invention relates to an arrangement of input-output (I/O) pins for an integrated circuit (IC).

There is a class of integrated circuits such as charge coupled device (CCD) in which the operation of the circuit is controlled based on the fundamental high frequency clock signals that are received by the circuit. In such a circuit, the signal that is needed for the operation of the circuit is arranged to be formed incessantly by internally switching the power supply signal by means of the fundamental clock signal. Due to such an arrangement, there is generated in general a high frequency electromagnetic wave with energy that is proportional to the strength of the fundamental clock signal. The electromagnetic wave thus generated tends to affect adversely the operation of other external circuits, especially of high frequency circuits (electromagentic wave interference). In particular, in prior art IC devices, the power supply current loops are long due to the arrangement for the I/O pins. Hence, the radiated energy of the high frequency electromagnetic wave is large, resulting in an electromagnetic wave interference which is large accordingly. In order to prevent the generation of such an electromagnetic wave interference, a countermeasure is ordinarily worked out such as to shield the integrated circuits that can potentially become the cause of the electromagnetic wave interference, along with the peripheral circuits. However, the shielding method is inconvenient in that it takes trouble for its implementation. Moreover, measures against a large electromagnetic wave interference such as the one mentioned in the above, necessarily involve factors that are largely technical skill in nature, so that there are cases in which the adaption of the shielding measure alone is often found to be insufficient. For this reason, appearance of other measures, in addition to the shielding measure, has been desired against the electromagnetic wave interference. In fact, urgently needed is the availability of an optimum measure which may be obtained, for example, by a combination of a plurality of measures depending upon the need.

From JP-A-59-222949 a superhigh integrated electronic circuit device is known which has a plurality of pads for external connection and reference potential and external connection and signal. The pads for external connection and reference potential are arranged to be mutually opposite to the pads for external connection and signal. The pads for external connection and reference are mutually coupled together by a wiring layer formed on the substrate of the superhigh integrated electronic circuit device.

An object of the present invention is to provide an arrangement of I/O pins for an IC device which is capable of contributing to the prevention of generation in other circuit of an adverse influence due to electro-magnetic wave interference.

Another object of the present invention is to provide an arrangement of I/O pins for an IC device which is capable of suppressing the generation of a high frequency radiation from the power supply current loops.

The above objects are solved in accordance with the invention by an integrated circuit device, comprising: an integrated circuit package; an integrated circuit chip (1) contained in said package, said integrated circuit chip including at least digital circuits which are to be operated by high frequency power signals; a set of first I/O pins which extend from said package and which are arranged to be connected, respectively, to first terminals of a plurality of power supplies required for providing said high frequency power signals; at least one second I/O pin which is to be connected to at least one second terminal of the plurality of power supplies, said at least one second terminal serving as a ground terminal; and bypass capacitors connected, respectively, between each of said first terminals and ground; said set of first I/O pins and said at least one second I/O pin being arranged adjacent to each other and at positions nearest to the digital circuits such that each first I/O pin, said integrated circuit chip, said at least one second I/O pin and a respective one of said bypass capacitors forms a current loop of minimized length.

These and other objects, features and advantages of the present invention will be more apparent from the following description of a preferred embodiment, taken in conjunction with the accompanying drawings.

Figure 1 is a block diagram for I/O pins of a prior art IC device; and

Fig. 2 is a block diagram for I/O pins of an IC device embodying the present invention.

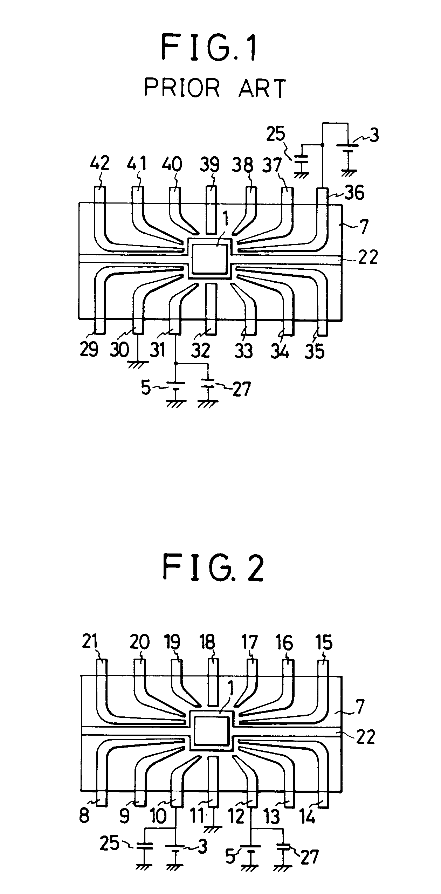

Referring to Fig. 2, there is shown an IC device of DIP-type package embodying the present invention.

As shown in the figure, the IC device comprises an IC chip 1, which is mounted on a pin 22 and is molded by a package 7 made of synthetic resins, and I/O pins 8 through 21. And, two kinds of power supply 3 and 5 (heareafter 3 and 5 will be referred to as "$V_{DD}$ power supply" and "$V_{CC}$ power supply", respectively) that are needed for operating the IC chip (referred to as "chip" hereafter) 1, and a ground that constitutes the common power supply for both power supplies 3 and 5, are connected to the I/O pins that are provided on the package 7 in the following manner. Namely, pins 10 and 12 constituting a set of first I/O pins (hereafter 10 and 12 will be referred to as "$V_{DD}$ power supply terminal" and "$V_{CC}$ power supply terminal", respectively) that are connected to the power supplies 3 and 5, respectively, are arranged at the positions that are on both sides of, and adjacent to, a pin (referred to as "ground terminal" hereafter) 11 constituting a second I/O pin to which the ground is connected, and at the same time, make both power supply terminals 10 and 12 and the ground terminal 11 to be closest to the chip 1. A feature of the present IC device is that, by arranging the terminals as in the above, the lengths of the power supply current loops that are formed between the two power supply terminals 10 and 12, and the ground terminal 11 can be minimized. Therefore, the high frequency radiation from the loops can be reduced. It should be noted in Fig.2 that in the neighborhood of both power supply terminals 10 and 12 there are provided bypass capacitors 25 and 27 for the $V_{DD}$ power supply 3 and the $V_{CC}$ power supply 5, respectively.

In other words, in an IC device that has the arrangement for terminals as described above, there are formed paths $V_{DD}$ power supply 3 → $V_{DD}$ power supply terminal 10 → chip 1 → ground terminal 11 → ground → bypass capacitor 25 → $V_{DD}$ power supply 3 and $V_{CC}$ power suppply 5 → $V_{CC}$ power supply terminal 12 → chip 1 → ground terminal 11 → ground → bypass capacitor 27 → $V_{DD}$ power supply 3 as the power supply current loops for high frequency component. That is, due to the arrangement that the power supply terminals 10 and 12 are set adjacent to the ground terminal 11 and at positions nearest to the chip 1, and that the bypass capacitors 25 and 27 are arranged in the respective neighborhood of both power supply terminals 10 and 12, the loop length of either of the high frequency component paths for power supply current can be made small.

Now, a general prior art IC device, as shown by Fig. 1, having arrangement of I/O pins with a large quantity of radiated energy of high frequency electromagnetic wave will be compared with the above embodiment of the present invention. In the IC device of Fig. 1, having the I/O pins 29 through 42, the pin 30 is used as the ground terminal. It has an arrangement of I/O pins in which the pin 31 that is situated adjacent to the ground terminal 30 is the $V_{CC}$ power supply terminal, and further, the pin 36 is the $V_{DD}$ power supply terminal. Further, other components of Fig. 1 that are identical to those in Fig. 2 are designated by identical symbols as in the latter to omit additional explanation.

In the IC device as shown in Fig. 1, a path $V_{CC}$ power supply 5 → $V_{CC}$ power supply terminal 31 → chip 1 → ground terminal 30 → ground → bypass capacitor 27 → $V_{CC}$ power supply 5 is formed as the power supply current loop due to the $V_{CC}$

power supply 5, and a path $V_{DD}$ power supply 3 → $V_{DD}$ power supply terminal 36 → chip 1 → ground terminal 30 → ground → bypass capacitor 25 → $V_{DD}$ power supply 3 is formed as the power supply current loop for the $V_{DD}$ power supply 3.

In the two paths, the former path is formed between the ground terminal 30 and the adjacently arranged $V_{CC}$ supply terminal 31 so that its path length is not much different from that in Fig. 2. However, the latter path is formed between the ground terminal 30 and the $V_{DD}$ power supply terminal 36 that is situated nearly diagonally removed from the ground terminal 30 on the IC device. Therefore, its loop length is necessarily longer than the path length in Fig. 2, described hereinbefore. This means that the amount of energy in the high frequency region that is radiated from these power supply current loops is greater than the amount of energy in the high frequency region radiated from the power supply current loops that are formed in the IC device of Fig. 2. In other words, it signifies that a reduction in the lengths of the power supply current loops is achieved by arranging the power supply terminals 9 and 11 adjacent to the ground terminal 10, resulting in an effect of suppressing the high frequency radiation from the loops.

Therefore, by devising a countermeasure against the electromagnetic wave interference, such as reduction in the lengths of the power supply current loops in the IC device itself, it may become possible at times to do without the shielding measure. Also, by employing the above method along with the shielding measure, it may be expected to become possible to prevent more positively the generation of an adverse influence due to electromagnetic wave interference.

It should be mentioned that although the description of the present embodiment given in the foregoing is made in conjunction with a DIP-type package, it will also be applicable naturally to other devices such as flat package, chip carrier type package, and pin grid array type package.

In addition, the construction described in the above is such that the $V_{DD}$ power supply terminal 10 and the $V_{CC}$ power supply terminal 12 are arranged on respective sides of the ground terminal 11. However, construction is not limited to this arrangement alone. Thus, for instance, an arrangement may also be made in which the $V_{DD}$ power supply terminal and the ground terminal are arranged on both sides of the $V_{CC}$ power supply terminal.

Moreover, the foregoing description of the embodiment was made for the case when there is just one ground for two power supplies 3 and 5. However, when there exist separate grounds for each of the two power supplies, similar effect can be expected by arranging the pins for each pair of power supply and ground to be adjacent to each other, and then by arranging the two sets of the power supply and ground pair adjacent to each other.

Furthermore, when one ground is shared by more than three power supplies, it becomes necessary to arrange the first and second I/O pins in such a way as to place each power supply terminal at a position which is adjacent to the ground terminal, in order to minimize the lengths of the power supply current loops. In particular, such consideration needs for applying the present concept to an IC device of the so-called pin grid array (PGA) type, rather than to a DIP-type IC device as was employed in connection with the description of the present embodiment.

In summary, according to the present invention, the I/O pins on the IC package are arranged such that the first I/O pins connected to the power supplies are positioned adjacent to the second I/O pins connected to the ground that correspond to respective power supplies. By so arranging, generation of a high frequency radiation from the power supply current loops can be suppressed by the reduction in the lengths of the power supply current loops. Therefore, such an arrangement can qualify as one sure and appropriate measure for preventing the generation of the electromagnetic wave interference.

## Claims

1.  An integrated circuit device, comprising:
    an integrated circuit package (7);
    an integrated circuit chip (1) contained in said package, said integrated circuit chip including at least digital circuits which are to be operated by high frequency power signals;
    a set of first I/O pins (10,12) which extend from said package and which are arranged to be connected, respectively, to first terminals of a plurality of power supplies (3,5) required for providing said high frequency power signals;
    at least one second I/O pin (11) which is to be connected to at least one second terminal of the plurality of power supplies, said at least one second terminal serving as a ground terminal;
    and bypass capacitors (25, 27) connected, respectively, between each of said first terminals and ground;
    said set of first I/O pins and said at least one second I/O pin being arranged adjacent to each other and at positions nearest to the digital circuits such that each first I/O pin, said integrated circuit chip, said at least one second I/O pin and a respective one of said bypass capacitors forms a current loop of minimized length.

2.  A device as claimed in claim 1, in which said second terminal connected to said second I/O pin is common to more than three power supplies and in which the integrated circuit package is a grid array type package.

3.  The device as claimed in claim 1, in which said second terminal connected to said second I/O pin is common to two power supplies and said second I/O pin is arranged between said first I/O pins.

4.  The device as claimed in claim 1, in which each power supply has a separate second terminal, a plurality of second I/O pins is provided, the second I/O pins being connected, respectively, to the second terminals, the first and second I/O pins for each first and second terminal of a power supply are arranged as a pair adjacent to each other, and in which said pairs are arranged adjacent to each other.

5.  The device as claimed in claim 1, in which the integrated circuit package is a DIP type package.

6.  The device as claimed in claim 1, in which the integrated circuit package is a flat package.

7.  The device as claimed in claim 1, in which the integrated circuit package is a chip carrier type package.

## Revendications

1.  Dispositif de circuit intégré comprenant :
    un boîtier de circuit intégré (7) ;
    une puce de circuit intégré (1) contenue dans le boîtier, cette puce pour circuit intégré comprenant au moins des circuits numériques qui doivent être mis en oeuvre par des signaux de puissance haute fréquence ;
    un ensemble de premières broches d'entrée/sortie (10, 12) qui s'étendent à partir du boîtier et qui sont disposées pour être connectées respectivement aux premières bornes d'une multitude d'alimentations en tension (3, 5) nécessaires pour délivrer ces signaux de puissance haute fréquence ;
    au moins une seconde broche d'entrée/sortie (11) qui doit être connectée à au moins une seconde borne de la multitude d'alimentations en tension, cette au moins seconde borne servant de borne de masse
    et des condensateurs de découplage (25, 27) connectés respectivement entre chacune des premières bornes et la masse ;
    cet ensemble de premières broches d'entrée/sortie et d'au moins une seconde broche d'entrée/sortie étant disposées mutuellement adjacentes et à des emplacements le plus près possible des circuits numériques de façon telle que chaque première broche d'entrée/sortie, la puce pour circuit intégré, la au moins une seconde broche d'entrée/sortie et le condensateur respectif des condensateurs de découplage forment une boucle de courant d'une longueur réduite au minimum.

2. Dispositif selon la revendication 1, dans lequel la seconde borne connectée à la seconde broche d'entrée/sortie est commune à plus de trois alimentations en tension et dans laquelle le boîtier de circuit intégré est un boîtier du type à matrice de broches.

3. Dispositif selon la revendication 1, dans lequel la seconde borne connectée à la seconde broche d'entrée/sortie est commune aux deux alimentations en tension et dans lequel la seconde broche d'entrée/sortie est disposée entre les premières broches d'entrée/sortie.

4. Dispositif selon la revendication 1, dans lequel chaque alimentation en tension comporte une seconde borne séparée, une multitude de secondes broches d'entrée/sortie étant prévues, les secondes broches d'entrée/sortie étant connectées respectivement aux secondes bornes, les première et seconde broches d'entrée/sortie pour chaque première et seconde bornes d'une alimentation en tension étant disposées comme une paire mutuellement adjacente et dans lequel ces paires sont disposées mutuellement adjacentes.

5. Dispositif selon la revendication 1, dans lequel le boîtier de circuit intégré est un boîtier du type à double rangée de connexions.

6. Dispositif selon la revendication 1, dans lequel le boîtier de circuit intégré est un boîtier plat.

7. Dispositif selon la revendication 1, dans lequel le boîtier de circuit intégré est un boîtier du type pavé de puce.

**Patentansprüche**

1. Integrierte Schaltungsvorrichtung, umfassend:

eine integrierte Schaltungspackung (7);

einen in der Packung enthaltenen integrierten Schaltungschip (1), wobei der integrierte Schaltungschip wenigstens digitale Schaltungen enthält, die durch hochfrequente Energiesignale betrieben werden sollen;

einen Satz von ersten I/O Stiften (10, 12), die von der Packung hervorstehen und die angeordnet sind, um jeweils an erste Anschlüsse einer Vielzahl von Energieversorgungen (3, 5) angeschlossen zu werden, die für die Bereitstellung der hochfrequenten Energiesignale benötigt werden;

wenigstens einen I/O Stift (11), der an wenigstens einen zweiten Anschluß der Vielzahl von Energieversorgungen angeschlossen werden soll, wobei wenigstens ein zweiter Anschluß als Masseanschluß dient;

und einen Überbrückungs-Kondensator (25, 27), der jeweils zwischen jedem der ersten Anschlüsse und Masse angeschlossen ist;

wobei der Satz von ersten I/O Stiften und wenigstens ein zweiter I/O Stift benachbart zueinander und an Positionen am nächsten zu den digitalen Schaltungen angeordnet sind, so daß jeder erste I/O Stift, der integrierte Schaltungschip, wenigstens ein zweiter I/O Stift und ein jeweiliger Überbrückungs-Kondensator eine Stromschleife von minimierter Länge bilden.

2. Vorrichtung nach Anspruch 1, wobei der zweite, an den zweiten I/O Stift angeschlossene Anschluß mehr als drei Energieversorgungen gemeinsam ist und die integrierte Schaltungspackung eine Gitter-Feld-Typ-Packung ist.

3. Vorrichtung nach Anspruch 1, wobei der zweite, an den zweiten I/O Stift angeschlossene Anschluß zwei Energieversorgungen gemeinsam ist und der zweite I/O Stift zwischen den ersten I/O Stiften angeordnet ist.

4. Vorrichtung nach Anspruch 1, wobei jede Energieversorgung einen getrennten zweiten Anschluß besitzt, eine Vielzahl von zweiten I/O Stiften vorgesehen ist, wobei die zweiten I/O Stifte jeweils an die zweiten Anschlüsse angeschlossen sind, und die ersten und zweiten I/O Stifte für jeden ersten und zweiten Anschluß einer Energieversorgung als ein zueinander benachbartes Paar angeordnet sind, und wobei die Paare zueinander benachbart angeordnet sind.

5. Vorrichtung nach Anspruch 1, wobei die integrierte Schaltungspackung eine DIP-Typ-Packung ist.

6. Vorrichtung nach Anspruch 1, wobei die integrierte Schaltungspackung eine Flach-Packung ist.

7. Vorrichtung nach Anspruch 1, wobei die integrierte Schaltungspackung eine Chip-Träger-Typ-Packung ist.

# FIG.1
## PRIOR ART

# FIG. 2